# EUROPÄISCHE PATENTSCHRIFT

(11) **EP 2 865 063 B1**
(45) Veröffentlichungstag und Bekanntmachung des Hinweises auf die Patenterteilung: **27.04.2016**
(21) Anmeldenummer: 13731722.8
(22) Anmeldetag: 19.06.2013
(51) Int. Cl.: H02J 3/12, H02J 13/00

(54) **NETZPLANERSTELLUNG UND BETRIEBSFÜHRUNG**
DETERMINING OF TOPOLOGY OF A GRID AND METHOD FOR OPERATING
PROCÉDÉ POUR DETERMINER LA TOPOLOGIE D'UN RÉSEAU ET SA GESTION

(30) Priorität: 22.06.2012 DE 102012105459
(43) Veröffentlichungstag der Anmeldung: 29.04.2015
(73) Patentinhaber: SMA Solar Technology AG, 34266 Niestetal (DE)
(72) Erfinder: PREMM, Daniel, 34260 Kaufungen (DE); FAWZY, Yehia Tarek, 34266 Niestetal (DE); BETTENWORT, Gerd, 34119 Kassel (DE); ALLERT, Claus, 34260 Kaufungen (DE); BÜLO, Thorsten, 34121 Kassel (DE); STEVENS, Stijn, 34329 Nieste (DE)
(74) Vertreter: Lahnor, Peter
(86) Internationale Anmeldenummer: PCT/EP2013/062702
(87) Internationale Veröffentlichungsnummer: WO 2013/189967

(56) Entgegenhaltungen:
- DE-A1-102010 006 142

## Beschreibung

### TECHNISCHES GEBIET DER ERFINDUNG

Die Erfindung bezieht sich auf ein Verfahren zum Ermitteln der Topologie eines Netzabschnitts eines Wechselstromnetzes, der einen Netzanschlusspunkt, mindestens einen von dem Netzanschlusspunkt abgehenden Strang mit mehreren Energieverbrauchs- und/oder -erzeugungseinheiten und mehrere Messpunkte in dem mindestens einen Strang umfasst, wobei das Verfahren die Merkmale des Oberbegriffs des unabhängigen Patentanspruchs 1 aufweist. Weiterhin bezieht sich die Erfindung auf Betriebsverfahren für eine Mehrzahl von Energieverbrauchs- und/oder -erzeugungseinheiten, die in einem Netzabschnitt eines Wechselstromnetzes angeordnet und in ihrer Anschlussleistung steuerbar sind, mit den Merkmalen des Oberbegriffs des unabhängigen Patentanspruchs 11.

Unter einem Netzabschnitt eines Wechselstromnetzes wird hier ein Bereich eines Wechselstromnetzes verstanden, der über seinen Netzanschlusspunkt an andere Bereiche des Wechselstromnetzes angeschlossen ist. Insbesondere kann an dem Netzanschlusspunkt ein Transformator vorgesehen sein, der eine Mittelspannung auf eine Niederspannung herunter transformiert, die in dem Netzabschnitt als Netznennspannung anliegt.

Wenn hier von Energieverbrauchs- und/oder -erzeugungseinheiten die Rede ist, so sollen hiermit auch Energiespeichereinheiten abgedeckt sein, die zeitweise wie eine Energieverbrauchseinheit Energie aufnehmen, um einen Energiespeicher zu laden, und unter Entladung des Speichers diese Energie zu anderen Zeiten wie eine Energieerzeugungseinheit abgeben. Außerdem fallen unter den Begriff der Energieverbrauchs- und/oder -erzeugungseinheiten auch Netzunterabschnitte mit mehreren Energieverbrauchs- und/oder -erzeugungseinheiten, die an den jeweiligen Strang des betrachteten Netzabschnitts über einen gemeinsamen Anschluss angeschlossen sind. Hierzu zählen insbesondere alle Energieverbrauchs- und/oder -erzeugungseinheiten in und an einem Gebäude, die über einen gemeinsamen Hausanschluss an einen Strang eines Netzabschnitts angeschlossen sind, oder mehrere Energieerzeugungseinheiten einer Energieerzeugungsanlage, die über einen Anlagenanschluss an einen Strang eines Netzabschnitts angeschlossen sind.

### STAND DER TECHNIK

Die zunehmende Verbreitung von kleinen und mittleren Energieerzeugungseinheiten, die irgendwo an ein Wechselstromnetz angeschlossen sind, macht eine Betriebsführung von Wechselstromnetzen zunehmend komplexer. Während bei zunehmender globaler Nachfrage nach elektrischer Leistung in einem Wechselstromnetz die Leistung eines zentralen Kraftwerks einfach erhöht werden kann, ohne dass in der Regel auf besondere Merkmale einer Topologie des Wechselstromnetzes, insbesondere auf Verknüpfungen der verschiedenen Netzebenen, Unterteilung einer Netzebene in einzelne Stränge sowie elektrische Relativlagen von Energieverbrauchs- und/oder -erzeugungseinheiten zueinander, Rücksicht genommen werden muss, gilt dies für dezentrale Energieerzeugungseinheiten bzw. Anlagen aus mehreren Energieerzeugungseinheiten insofern nicht, als aufgrund lokaler Ungleichgewichte zwischen Erzeugung und Verbrauch elektrischer Leistung schnell Probleme mit der Verteilung der Leistung in dem Wechselstromnetz auftreten. So kann durch dezentrale Energieerzeugungseinheiten bereits ein lokales Überangebot an elektrischer Leistung vorliegen, auch wenn die Nachfrage in dem Wechselstromnetz das Angebot an elektrischer Leistung insgesamt überschreitet. Eine weitere Steigerung der Energieeinspeisung dieser dezentralen Energieerzeugungseinheiten führt dann zu einem zumindest lokalen Verlassen des zulässigen Arbeitsbereichs des Wechselstromnetzes, beispielsweise zu einem Überschreiten von Spannungsgrenzwerten und/oder einer Überlastung von Betriebsmitteln, insbesondere von elektrischen Leitungen. Genauso nutzt es unter diesen Umständen wenig, eine Energieverbrauchseinheit in einem Bereich des Wechselstromnetzes, in dem das Überangebot an elektrischer Leistung herrscht, abzuschalten, um auf diese Weise das insgesamt herrschende Unterangebot von elektrischer Leistung zu reduzieren. Insbesondere ist eine Betriebsführung eines Wechselstromnetzes mit Hilfe von globalen Rundsteuersignalen, die alle angeschlossenen steuerbaren Energieerzeugungseinheiten und Energieverbrauchseinheiten gleichermaßen ansprechen, zur Lösung dieses Widerspruchs zwischen lokalen und globalen Problemen ungeeignet.

Aus der DE 10 2010 006 142 A1 ist ein Energieportal zur Steuerung bzw. Regelung einer Energieeinspeisung aus einem Erzeugernetz unter Berücksichtung von Einspeisefaktoren, Erzeugernetzmessgrößen und Prognoseinformationen zur Steuerung bzw. Regelung von Betriebsparametern des Erzeugernetzes bekannt. Das Energieportal umfasst eine Einspeisefaktoren-Empfangsvorrichtung zum Empfangen von vorgebbaren Einspeisefaktoren eines Energieverteilungsnetzbetreibers, eine Erzeugermessgrößen-Empfangsvorrichtung zum Empfangen von Messgrößen eines Erzeugernetzes, eine Prognoseinformations-Empfangsvorrichtung zum Empfangen von Prognoseinformation, eine Auswertevorrichtung zum Auswerten der Messgrößen, Einspeisefaktoren und Prognoseinformation, und eine Betriebsparameterregelvorrichtung zum Steuern bzw. Regeln von Betriebsparametern des Erzeugernetzes auf der Grundlage der ausgewerteten Messgrößen, Einspeisefaktoren und Prognoseinformation mit den Einspeisefaktoren als Regelgröße. Auf diese Weise soll erreicht werden, dass die von dem Energieverteilungsnetzbetreiber vorgegebenen Einspeisefaktoren eingehalten werden. Tatsächlich kann dieses Ergebnis aber nur bei genauer Kenntnis der Topologie des gesamten Wechselstromnetzes erreicht werden.

Aus der DE 10 2007 055 517 A1 ist ein Verfahren zum Betreiben eines Energieversorgungsnetzwerks bekannt. Das Energieversorgungsnetzwerk umfasst zumindest ein oder mehrere Energieerzeugungseinheiten und/oder ein oder mehrere Energieverbrauchseinheiten, wobei diesen jeweils eine oder mehrere Versorgungsklassen mit vorgegebener Priorität zugewiesen wird/werden. Auf Basis der Versorgungsklassen erfolgt eine rechnergestützte Steuerung der Energieerzeugungseinheit in Bezug auf die Energieeinspeisung und/oder der Energieverbrauchseinheit in Bezug auf den Energieverbrauch. Im Rahmen des bekannten Verfahrens soll eine rechnergestützte Erfassung der Topologie des Energieversorgungsnetzwerks erfolgen, um eine bedarfsgerechte Steuerung jeweiliger Einheiten des Energieversorgungsnetzwerks zu ermöglichen. Topologiedaten eines Energieversorgungsbereichs sollen die Struktur des Versorgungsleitungsnetzes sowie statische Gerätewerte der Einheiten in dem betreffenden Energieversorgungsbereich repräsentieren. Die Struktur des Leitungsnetzes soll dabei durch Datenaustausch zwischen jeweiligen Stromverteilungsrechnern und einem Bereichsrechner automatisch erkannt werden. Der Bereichsrechner soll periodisch die Gerätewerte abrufen, um die Topologiedaten für den Energieversorgungsbereich pflegen zu können. Konkret soll ein Stromverteilungsrechner, wenn er an eine Versorgungsleitung angeschlossen wird, selbsttätig erfassen, welche Einheiten bereits an der betreffenden Versorgungsleitung angeschlossen sind. Hierbei misst er physikalische Leitungsdaten, wie zum Beispiel die Impedanz. Im Anschluss daran werden die durch den Stromverteilungsrechner gewonnenen Informationen an den Bereichsrechner des betreffenden Energieversorgungsbereichs übermittelt. Der Bereichsrechner verwendet diese Daten für die Erstellung der Topologie des Energieversorgungsbereichs. Diese Maßnahmen sind aber unzureichend, um eine Topologie eines Netzabschnitts in eine für eine optimierte Betriebsführung in dem Netzabschnitt ausreichenden Genauigkeit zu bestimmen.

Aus der DE 10 2008 057 563 A1 sind ein Verfahren und eine Vorrichtung zum netzkonformen Betreiben eines Niederspannungsnetzes mit einer Mehrzahl von dezentralen Energieerzeugungseinheiten und/oder Energieverbrauchseinheiten bekannt. Die Einheiten sind zum Austausch von Informationen über ein Kommunikationsmedium mit einer übergeordneten, allen Einheiten gemeinsamen Einrichtung verbunden, die von einem Energiehändler betrieben wird. Jede Einheit weist einen Energiemanager auf, der mittels eines Optimierungsprogramms und eines festgelegten Tarifprofils einen für seine Energieverbrauchseinheit und Erzeuger wirtschaftlich günstigen Einsatzplan berechnet. Ein netzkonformer Betrieb wird dadurch erreicht, dass an Netzanschlusspunkten der Einheiten sich ergebene Netzparameter auf die Einhaltung von Ihnen zugewiesenen Toleranzbereichen überwacht werden, und dass die übergeordnete Einrichtung, wenn die Netzparameter wenigsten einem Netzanschlusspunkt die ihnen zugewiesenen Toleranzbereiche verlassen, zumindest an eine kritische Einheit ein abgeändertes Tarifprofil übermittelt, um dadurch die Netzparameter den Toleranzbereichen zumindest wieder anzunähern. Wenn mit diesem bekannten Verfahren die Betriebsführung eines Netzabschnitts optimiert werden soll, müssen alle relevante Mengen an Energie verbrauchenden oder erzeugenden Einheiten mit der von dem Energiehändler betriebenen Einheit verbunden sein. Zudem ist die indirekte Steuerung der Einheiten über die ihnen übermittelten Tarifprofile träge.

Aus der EP 2 012 132 A1 ist ein Verbrauchs- und Zustandsmesser bekannt, der eine Analysevorrichtung für Stromverbraucher aufweist. Einzelne Verbraucher werden an dem Fingerabdruck ihres Verbrauchs erkannt. Wenn der Verbrauch an unterschiedlichen Steckdosen erfasst wird, wird auch erkannt, an welche Steckdose der jeweilige Verbraucher angeschlossen ist.

### AUFGABE DER ERFINDUNG

Der Erfindung liegt die Aufgabe zugrunde, ein Verfahren zum Ermitteln der Topologie eines Netzabschnitts eines Wechselstromnetzes aufzuzeigen, das ausreichende Informationen über die zunächst unbekannte Topologie des Netzabschnitts bereitstellt, um mit Energieverbrauchs- und/oder -erzeugungseinheiten, die bezüglich ihrer Anschlussleistung steuerbar sind, die Betriebsführung des Wechselstromnetzes in dem Netzabschnitt zu optimieren.

### LÖSUNG

Die Aufgabe der Erfindung wird durch ein Verfahren zum Ermitteln der Topologie eines Netzabschnitts eines Wechselrichters mit den Merkmalen des unabhängigen Patentanspruchs 1 gelöst. Die abhängigen Patentansprüche 2 bis 10 sind auf bevorzugte Ausführungsformen dieses Verfahrens gerichtet. Patentanspruch 11 betrifft ein Betriebsverfahren für eine Mehrzahl von Energieverbrauchs- und/oder -erzeugungseinheiten, bei dem die Topologie nach dem erfindungsgemäßen Verfahren ermittelt wird; und die abhängigen Patentansprüche 12 bis 14 sind auf bevorzugte Ausführungsform dieses Betriebsverfahrens gerichtet.

### BESCHREIBUNG DER ERFINDUNG

Ausgehend von einem grundsätzlich bekannten Verfahren, bei dem die Anschlussleistung mindestens einer von mehreren Energieverbrauchs- und/oder -erzeugungseinheiten sowie Variationen der Netzspannung an mindestens einem Messpunkt, wie beispielsweise direkt an der mindestens einen Energieverbrauchs- und/oder -erzeugungseinheit gemessen werden, werden bei einem erfindungsgemäßen Verfahren zum Ermitteln der Topologie eines Netzabschnitts eines Wechselstromnetzes Abhängigkeiten von Variationen der Netzspannung an dem mindestens einen Messpunkt von Variationen der Anschlussleistungen von zumindest einigen einzelnen der mehreren Energieverbrauchs- und/oder -erzeugungseinheiten in dem Netzabschnitt bestimmt.

Bei den Variationen der Anschlussleistungen handelt es sich um Variationen der Wirkleistung und/oder der Blindleistung der jeweiligen Energieverbrauchs- und/oder -erzeugungseinheiten. Diese Variationen wirken sich auf die an dem mindestens einen Messpunkt gemessene Netzspannung unterschiedlich aus, je nach dem welche elektrischen Relativlagen innerhalb des Netzabschnittes zwischen den jeweiligen Energieverbrauchs- und/oder -erzeugungseinheiten und dem mindestens einen Messpunkt gegeben sind. Dabei sind die elektrischen Relativlagen insbesondere durch eine Zuordnung zu derselben oder einer anderen Phase, durch eine Zuordnung zu demselben oder einem anderen Strang innerhalb des Netzabschnitts und/oder durch eine relative Reihenfolge innerhalb eines Stranges, beispielsweise einen relativen Abstand zu einem Netzanschlusspunkt, z.B. einem Ortsnetztrafo, definiert. So können umgekehrt aus den bestimmten Abhängigkeiten Rückschlüsse auf die elektrischen Relativlagen der einzelnen Energieverbrauchs- und/oder -erzeugungseinheiten zu dem mindestens einen Messpunkt und dem Netzanschlusspunkt des Netzabschnitts gezogen werden. Konkret kann aus den bestimmten Abhängigkeiten ermittelt werden, ob ein Messpunkt und eine Energieverbrauchs- und/oder -erzeugungseinheit an derselben Phase und/oder in demselben Strang des Netzabschnittes angeschlossen sind. Wenn ein Messpunkt und eine Energieverbrauchs- und/oder -erzeugungseinheit in demselben Strang angeschlossen sind, kann zudem die von dem Netzanschlusspunkt aus gesehene Reihenfolge des Anschlusses, d.h. der relative Abstand zu einem Netzanschlusspunkt ermittelt werden.

Die zur Ermittlung der elektrischen Relativlagen verfügbaren Informationen steigen mit der Anzahl und der Verteilung der Messpunkte an, an denen die Netzspannung gemessen wird. Bei der Bestimmung und/oder anschließenden Darstellung der elektrischen Relativlagen der Energieverbrauchs- oder Energieerzeugungseinheit und der Messpunkte können bekannte elektrische oder räumliche Relativlagen, die beispielsweise mit Hilfe von geographischen Informationssystemen gewonnen wurden, als Bezugspunkte verwendet werden.

Das Ergebnis des erfindungsgemäßen Verfahrens kann demnach ein Netzplan sein, auf dem die Lagen der einzelnen Energieverbrauchs- und/oder -erzeugungseinheiten gegenüber den Messpunkten verzeichnet sind. Für eine sich anschließende optimierte Betriebsführung des Wechselstromnetzes in dem Netzabschnitt ist ein solcher Netzplan jedoch keine zwingende Voraussetzung. Die interessierende Topologie, d. h. die elektrischen Relativlagen der einzelnen Energieverbrauchs- und/oder -erzeugungseinheiten und der Messpunkten sind in ihren relevanten Auswirkungen bereits dadurch ausreichend bestimmt, dass die Abhängigkeiten der Variationen der Netzspannung an den Messpunkten von den Variationen der Anschlussleistungen der einzelnen Energieverbrauchs- und/oder -erzeugungseinheiten in normierter Form bekannt sind. Diese Abhängigkeiten geben an, wie, d. h. zum Beispiel mit welcher Impedanz, durch eine Variationen der Anschlussleistungen der Energieverbrauchs- oder -erzeugungseinheiten auf die Netzspannung an den verschiedenen Messpunkten Einfluss genommen werden kann. Genau dies ist aber die entscheidende Kenntnis, die für eine Optimierung der Betriebsführung des Wechselstromnetzes in dem Netzabschnitt benötigt wird. Konkret kann das Ergebnis des erfindungsgemäßen Verfahrens daher auch eine Matrize sein, die die Abhängigkeiten der Netzspannung von den Anschlussleistungen der einzelnen Energieverbrauchseinheiten und Energieerzeugungseinheiten in normierter Form wiedergibt. Zum Beispiel zur Erstellung einer solchen Matrize können die elektrischen Relativlagen der einigen einzelnen Energieverbrauchsoder -erzeugungseinheiten anhand einer Korrelationsanalyse der Variationen der Netzspannungen und der Variationen der Anschlussleistungen ermittelt werden.

Bei dem erfindungsgemäßen Verfahren können die Variationen der Anschlussleistungen an allen Energieverbrauchs- oder Erzeugungseinheiten direkt gemessen werden. Diese Daten sind häufig von zumindest einigen der Energieverbrauchs- und/oder -erzeugungseinheiten verfügbar. Grundsätzlich können die Variationen der Anschlussleistungen einzelner Energieverbrauchs- oder Erzeugungseinheiten aber auch aus den resultierenden Variationen der Netzspannung an dem mindestens einen Messpunkt abgeleitet werden. Wenn Abhängigkeiten der Variationen der Netzspannung von Variationen gemessener Anschlussleistungen aus der elektrischen Nähe dieser Energieverbrauchs- und/oder -erzeugungseinheiten verfügbar sind, sind aus den resultierenden Variationen der Netzspannung nicht nur relative, sondern auch absolute Werte der Variationen der nicht (direkt) gemessenen Anschlussleistungen ermittelbar. Wenn die Variationen der Anschlussleistungen aus den Variationen der Netzspannung abgeleitet werden sollen, besteht jedoch eine erhöhte Schwierigkeit, die Variationen der Netzspannung einzelnen Energieverbrauchseinheiten und/oder Energieerzeugungseinheiten bzw. den Variationen deren Anschlussleistungen zuzuordnen. Diese Zuordnung kann jedoch anhand von charakteristischen Zeitverläufen der Anschlussleistungen der Energieverbrauchs- und/oder -erzeugungseinheiten geschehen. Insbesondere ermöglicht eine solche Analyse auf Korrelationen zwischen Variationen der gemessenen Netzspannung und für bestimmte Energieverbrauchs- und/oder -erzeugungseinheiten charakteristischen Variationen ihrer Anschlussleistung eine Identifikation dieser Energieverbrauchs- und/oder -erzeugungseinheiten in dem Netzabschnitt.

So können zunächst unbekannte Energieerzeugungseinheiten anhand von Variationen der Netzspannung, die durch Variationen ihrer Anschlussleistungen, die gegenüber grundsätzlich gleichen Variationen direkt gemessener Anschlussleistungen bekannter Energieerzeugungseinheiten systematisch zeitlich versetzt sind, hervorgerufen werden, erkannt und dann bezüglich ihrer elektrischen Lage eingeordnet werden. Dies ist insbesondere dann möglich, wenn es sich bei den Energieerzeugungseinheiten um solche handelt, deren Anschlussleistung von Wettereinflüssen wie Sonneneinstrahlung oder Windgeschwindigkeit bestimmt ist, und diese Wettereinflüsse lokale Variationen aufweisen, deren räumliche Verteilung sich im wesentlichen unverändert über den Netzabschnitt hinweg bewegt. Wenn beispielsweise eine Wolke über den räumlichen Bereich des Netzabschnitts hinweg zieht, führt sie zu unterschiedlichen Zeitpunkten zu charakteristischen Variationen der Anschlussleistungen von PV-Generatoren aufweisenden Energieerzeugungseinheiten. Ähnliches gilt für eine Windböe bzw. eine Wetterfront mit starkem Luftdruckunterschied, die zu unterschiedlichen Zeitpunkten verschiedene Windenergieanlagen erreichen und dort zu charakteristischen Variationen ihrer Anschlussleistungen führt. Diese Variationen, d. h. ein vorübergehendes Einbrechen oder Ansteigen der Anschlussleistung, können dann, wenn sie an einer der Energieerzeugungseinheiten konkret erfasst wurden, verwendet werden, um gleichartige Energieerzeugungseinheiten aufgrund eines gleichen Musters ihrer Auswirkungen auf die Netzspannung an dem mindestens einen Messpunkt mittels Korrelationsanalyse zu erkennen. Wenn zugleich die Windrichtung und Windgeschwindigkeit bekannt sind, können neben den elektrischen Relativlagen der zunächst unbekannten Energieerzeugungseinheiten auch deren räumliche Lage bestimmt werden.

Konkret kann zur Korrelationsanalyse eine Korrelation eines Zeitverlaufes der Anschlussleistung, im Falle einer wetterbedingten Variation der Anschlussleistung insbesondere eine Korrelation eines Zeitverlaufes der Wirkleistung einer der Energieerzeugungseinheiten, mit den Zeitverläufen der Netzspannung an dem mindestens einen Messpunkt ermittelt werden. Dann kann eine Autokorrelation eines oder mehrerer Zeitverläufe der an einem oder mehreren Messpunkten gemessenen Netzspannung ermittelt werden, um nach gleichartigen Variationen der Netzspannung zu suchen, die nicht auf die bekannten Variationen der Anschlussleistung der einen Energieerzeugungseinheit zurückgehen. Als Ergebnis erhält man die Information, ob eine gleichartige Energieerzeugungseinheit im Netzabschnitt vorhanden ist, indem eine von dieser durch die zeitlich versetzte Variation ihrer Anschlussleistung hervorgerufene zeitlich versetze Variation der Netzspannung auftritt und als korrelierendes Ereignis erkennbar ist. Insbesondere dann, wenn der mindestens eine Messpunkt Teil einer Energieerzeugungseinheit ist, kann die Energieerzeugungseinheit auf diese Weise für ihren Betrieb relevante Informationen über die Topologie des sie umgebenden Netzabschnittes ermitteln und darauf basierend beispielsweise ihren Beitrag zur Netzstützung, insbesondere eine Abhängigkeit der Wirkleistungseinspeisung und/oder der Blindleistungsbereitstellung in Abhängigkeit von Netzeigenschaften wie der Netzfrequenz und/oder der Netzspannung anpassen.

Für den Fall, dass eine Vielzahl von Messpunkten vorhanden sind, die jeweils Teil einer Energieerzeugungseinheit sein können, können auch Kreuzkorrelationen zwischen den Zeitverläufen der Anschlussleistungen und den Zeitverläufen der Netzspannungen durchgeführt werden; daraus ergeben sich wiederum Informationen über die elektrischen Relativlagen der Energieerzeugungsanlagen zueinander, indem eine Amplitude der Kreuzkorrelation sowohl von der jeweiligen Zuordnung der Energieerzeugungseinheiten zu den Phasen und den Strängen des Netzabschnittes als auch von der Reihenfolge des Anschlusses der Energieerzeugungseinheiten in einem Strang, mithin vom Abstand der Energieerzeugungseinheiten zum Netzanschlusspunkt abhängt.

Bislang wurden ausschließlich zufällige oder durch nicht beeinflussbare Ereignisse hervorgerufene Variationen der Anschlussleistungen der Energieverbrauchs- und/oder -erzeugungseinheiten betrachtet. Eine vereinfachte Zuordnung auftretender Variationen der Netzspannung an dem mindestens einen Messpunkt ist aber dann gegeben, wenn die Variationen der Anschlussleistungen der jeweils interessierenden einzelnen Energieverbrauchs- oder Energieerzeugungseinheiten mit einem charakteristischen Verlauf erzwungen werden und so zu einem bekannten Zeitpunkt und mit bekanntem Verlauf auftreten. Hierzu zählt das gezielte Einschalten der jeweiligen Energieverbrauchs- und/oder -erzeugungseinheit ebenso wie eine gezielte Variation ihrer Anschlussleistung, die auch mit einem bestimmten Frequenzmuster kodiert sein kann, um sie einer bestimmten Variation der Netzspannung an dem mindestens einen Messpunkt fehlerfrei zuordnen zu können.

Bei den Variationen der Anschlussleistungen werden vorzugsweise getrennt voneinander Variationen die Wirkleistung und der Blindleistung der jeweiligen Energieverbrauchs- und/oder -erzeugungseinheiten betrachtet. Dies gilt insbesondere dann, wenn die Ermittlung der Topologie des jeweiligen Netzabschnitts Grundlage für eine Betriebsführung des Wechselstromnetzes in dem Netzabschnitt ist, die die Netzspannung sowohl durch gezielte Einspeisung bzw. gezielten Verbrauch von Wirkleistung als auch durch gezielte Erzeugung von Blindleistung beeinflussen soll. Wenn das Ergebnis des erfindungsgemäßen Verfahrens eine Matrize ist, die die Abhängigkeiten der Netzspannung von den Anschlussleistungen der einzelnen Energieverbrauchseinheiten und Energieerzeugungseinheiten in normierter Form wiedergibt, handelt es sich dann um eine Matrize mit komplexen Einträgen oder zwei getrennte Matrizen für die Abhängigkeiten der Netzspannung von der Wirkleistung und der Blindleistung der Anschlussleistungen. Zudem können insbesondere bei Kenntnis der Zuordnung der Messpunkte und der einzelnen Energieverbrauchseinheiten und Energieerzeugungseinheiten zu den einzelnen Phasen des Netzabschnittes für jede Phase getrennte Matrizen erstellt werden.

Da das erfindungsgemäße Verfahren die Abhängigkeiten der Variationen der Netzspannung von den Variationen der Anschlussleistungen einzelner Energieverbrauchs- und/oder -erzeugungseinheiten, d. h. die Sensitivität des Netzes bestimmt, können umgekehrt auch Änderungen der Anschlussleistungen von einzelnen Energieverbrauchs- und/oder -erzeugungseinheiten als Reaktion auf Änderungen der Netzspannung im Hinblick auf eine optimierte Betriebsführung modifiziert werden. Konkret können zum Beispiel Kennlinien, welche die Anschlussleistungen der Energieverbrauchs- und/oder -erzeugungseinheiten in Abhängigkeit von gemessenen Netzzustandsgrößen bestimmen, derart optimiert werden, dass Energieverbrauchs- und/oder -erzeugungseinheiten, die an Stellen mit größerer Sensitivität an das Netz angeschlossen sind, mittels einer steileren Kennlinie stärker zur Spannungsstützung beitragen als solche an Stellen mit kleinerer Sensitivität; ein Beispiel dafür ist die gezielte Erzeugung von Blindleistung durch Energieerzeugungseinheiten nahe dem Netzanschlusspunkt. Umgekehrt kann es sinnvoll sein, Energieverbrauchs- und/oder -erzeugungseinheiten an Stellen mit großer Sensitivität mittels einer flacheren Kennlinie zu geringeren Änderungen ihrer Anschlussleistungen bei Variationen der Netzspannung zu veranlassen, beispielsweise um unnötige Fluktuationen der Einspeisung einer Energieerzeugungseinheit am Ende eines Strangs, also weit entfernt vom Netzanschlusspunkt, die sich unmittelbar auf die Netzspannung im gesamten Strang auswirken, zu vermeiden.

Bei einem erfindungsgemäßen Betriebsverfahren für eine Mehrzahl von Energieverbrauchseinheiten und/oder Energieerzeugungseinheiten, die in einem Netzabschnitt eines Wechselstromnetzes angeordnet und in ihrer Anschlussleistung zum Erreichen mindestens eines vorgegebenen Optimierungsziels steuerbar sind, wobei beim Steuern der Energieverbrauchs- und/oder -erzeugungseinheiten eine Topologie des Netzabschnitts berücksichtigt wird, wird die Topologie nach dem voranstehend beschriebenen erfindungsgemäßen Verfahren ermittelt. Da die mehreren Energieverbrauchs- und/oder -erzeugungseinheiten in diesem Fall steuerbar sind, ist es bevorzugt, ihre Anschlussleistungen gezielt getrennt voneinander zu variieren, um die relevanten Variationen der Anschlussleistungen und die resultierenden Variationen der Netzspannung hervorzurufen. Darüber hinaus können in dem Netzabschnitt weitere aktive Betriebsmittel vorhanden sein, beispielsweise regelbare Transformatoren, fernschaltbare Trennstellen oder spezielle Blindleistungsquellen, die im Rahmen des Betriebsverfahrens zum Erreichen des mindestens eines vorgegebenen Optimierungsziels steuerbar sind.

Die festgestellten Abhängigkeiten der Netzspannung an den einzelnen Messpunkten von den Variationen der Anschlussleistung der einzelnen Energieverbrauchs- und Energieerzeugungseinheiten lassen bei dem erfindungsgemäßen Betriebsverfahren eine einfache Abschätzung zu, wie sich eine Änderung der jeweiligen Anschlussleistung auf die Netzspannung an den verschiedenen Messpunkten auswirkt. Danach können zum Beispiel die ansteuerbaren Energieverbrauchs- und/oder Energieerzeugungseinheiten sowie ggf. vorhandene aktive Betriebsmittel gezielt angewählt werden, mit denen eine gegebene Verteilung der Netzspannung über die Messpunkte am effektivsten in eine gewünschte Verteilung der Netzspannung über die Anschlusspunkte verändert werden kann. Insbesondere können auch unerwünschte Auswirkungen der Veränderung der Anschlussleistung von einzelnen Energieverbrauchs- oder Energieerzeugungseinheiten entweder von vornherein vermieden oder durch geeignete Gegenmaßnahmen kompensiert werden.

Bei dem erfindungsgemäßen Betriebsverfahren kann das mindestens eine Optimierungsziel, das durch Ansteuern der Energieverbrauchs- und/oder Energieerzeugungseinheiten sowie ggf. vorhandener aktiver Betriebsmittel erreicht wird, zum Beispiel ausgewählt werden aus:
- Einem Fernhalten aller Betriebsparameter des Netzabschnitts von Stabilitätsgrenzen. Dieser Aspekt betrifft insbesondere das Halten der Netzspannung in einem vorgegebenen Wertebereich und die Verfügbarkeit von Wirkleistung in allen Teilen des Netzabschnitts.
- Einem definierten Lastfluss an einem bestimmten Punkt im Wechselstromnetz, insbesondere am Netzanschlusspunkt, über den der Netzabschnitt an das weitere Wechselstromnetz angeschlossen ist. Zu diesem Aspekt zählt es insbesondere auch, zu verhindern, dass über eine von mehreren Phasen des Wechselstromnetzes elektrische Energie über den Netzanschlusspunkt für den Netzabschnitt bezogen wird, während über eine andere Phase elektrische Energie von dem Netzabschnitt in das weitere Wechselstromnetz eingespeist wird.
- Einer maximalen Nutzung einer in dem Netzabschnitt zur Verfügung stehenden Netzkapazität. Dabei geht es insbesondere darum, Leitungen des Wechselstromnetzes im Bereich des Netzabschnitts zwar nicht zu überlasten, aber doch maximal auszulasten, um angesichts knapper Netzkapazitäten sicherzustellen, dass die Leistung insbesondere fluktuierender regenerativer Energiequellen maximal genutzt werden kann.
- Einer maximalen Schonung der steuerbaren Energieverbrauchs- und/oder -erzeugungseinheiten. Die Rentabilität von Energieerzeugungseinheiten hängt erheblich davon ab, wie lange sie ohne zusätzliche Investitionen betrieben werden können. Das Erreichen einer maximalen Lebensdauer setzt dabei einen schonenden Umgang mit den Energieverbrauchs- und/oder -erzeugungseinheiten voraus. In ganz besonderem Maße gilt dies für Energiespeichereinheiten, insbesondere in Hinblick auf die nutzbare Ladekapazität von deren Akkumulatoren, die u.a. von der Anzahl der Lade-/Entladezyklen abhängt.
- Einer allgemeinen Maximierung wirtschaftlicher Vorteile. Diese können von aktuellen Tarifbedingungen abhängig sein, die dann entsprechend zu berücksichtigen sind.
- Einer maximalen Nutzung von Energie aus regenerativen Energieerzeugungseinheiten. Mit regenerativen Energieerzeugungseinheiten sind dabei alle Energieerzeugungseinheiten gemeint, deren Generatoren von regenerativen Energien Gebrauch machen, wie beispielsweise Solarenergie oder Windenergie. Möglichst nur Energie aus regenerativen Energieerzeugungseinheiten zu verbrauchen, ist gleichbedeutend damit, möglichst wenig andere, insbesondere konventionell aus fossilen Rohstoffen erzeugte Energie in Anspruch zu nehmen.

Von den genannten Optimierungszielen können mehrere nacheinander angestrebt werden, wobei dann zum Erreichen jedes weiteren Optimierungsziels jeweils möglichst nur solche Maßnahmen ergriffen werden, die dem Erhalten eines bereits erreichten Optimierungsziels nicht entgegenstehen.

Alternativ können auch mehrere Optimierungsziele gleichzeitig angestrebt werden. Dabei können diese mehreren Optimierungsziele sowohl gleich als auch unterschiedlich gewichtet werden. So kann für das teilweise Erreichen jedes Optimierungsziels ein eigener Bewertungsmaßstab festgelegt werden, wobei dann die Summe der erreichten Bewertungen maximiert wird, um die Gesamtheit der mehreren Optimierungsziele gemäß ihrer Gewichtung möglichst weitgehend zu erreichen.

Das mindestens eine Optimierungsziel und/oder die Reihenfolge oder Gewichtung mehrerer Optimierungsziele können bei dem erfindungsgemäßen Betriebsverfahren insbesondere von einem Betreiber des Wechselstromnetzes vorgegeben werden. Beim Ausbleiben solcher Vorgaben können allgemeine Optimierungsziele, wie beispielsweise die Netzstabilität oder die maximale Nutzung von Energie aus regenerativen Energieerzeugungseinheiten berücksichtigt werden.

Die erfindungsgemäß ermittelten Abhängigkeiten der Netzspannung an den einzelnen Messpunkten von der Anschlussleistung der einzelnen Energieverbrauchs- und/oder -erzeugungseinheiten lässt zwar vielfach erkennen, wie mit bestimmten Einheiten lokal optimal eingegriffen wird. Dennoch kann es sinnvoll sein, die steuerbaren Energieverbrauchs- und/oder Energieerzeugungseinheiten sowie ggf. vorhandene aktive Betriebsmittel bezüglich ihrer Effizienz bei der Ansteuerung zum Erreichen des mindestens einen Optimierungsziels zu ranken, d. h. einzuordnen, und grundsätzlich in der Reihenfolge ihres Rankings zum Erreichen des jeweiligen Optimierungsziels anzusteuern. Zumindest wird es sinnvoll sein das Ranking bei der Betriebsführung zu berücksichtigen. Dies bedeutet beispielsweise, das Blindleistung zur Stabilisierung der Netzspannung mit problemlos blindleistungsfähigen Energieerzeugungseinheiten bereitgestellt wird, und nicht beispielsweise mit hierzu weniger geeigneten Energieerzeugungseinheiten, nur weil diese näher an dem Messpunkt liegen, an dem die Netzspannung erhöht werden soll. Darüber hinaus kann die Kenntnis der Anschlussleistungen zumindest einiger Energieverbrauchs- und/oder -erzeugungseinheiten in einem Netzabschnitt genutzt werden, um alle weiteren, an sich nicht bekannten Energieverbrauchs- bzw. -erzeugungseinheiten in Gruppen von jeweils äquivalenten Energieverbrauchs- bzw. -erzeugungseinheiten zusammenzufassen, um alle Energieverbrauchs- bzw. -erzeugungseinheiten jeder dieser Gruppen hinsichtlich eines Zeitverlaufes ihres gemeinsamen Verbrauchs- bzw. Erzeugungsprofils auszuwerten. Damit wird eine weitere Verbesserung des Betriebsverfahrens ermöglicht.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten relativen Anordnungen mehrerer Bauteile zueinander sowie deren Wirkverbindungen - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Die Erfindung wird im Folgenden anhand der beigefügten Zeichnungen erläutert und beschrieben.
- **Fig. 1**: zeigt schematisch einen Netzabschnitt, der an einem Netzanschlusspunkt über einen Transformator an den Rest eines Wechselstromnetzes angeschlossen ist;
- **Fig. 2**: zeigt eine Matrize der Abhängigkeiten der an verschiedenen Messpunkten des Netzabschnitts gemäß Fig. 1 gemessenen Variationen der Netzspannung von Variationen der Wirkleistung der Anschlussleistungen verschiedener Energieverbrauchs- und/oder -erzeugungseinheiten in dem Netzabschnitt;
- **Fig. 3**: zeigt eine Fig. 2 entsprechende Matrize der Abhängigkeiten der Variationen der Netzspannung von der Blindleistung der Anschlussleistungen der einzelnen Energieverbrauchs- und/oder -erzeugungseinheiten; und
- **Fig. 4**: zeigt ein Ablaufdiagramm einer Ausführungsform eines erfindungsgemäßen Betriebsverfahrens für eine Mehrzahl von Energieverbrauchs- und/oder -erzeugungseinheiten in einem Netzabschnitt, bei der verschiedene Optimierungsziele sequentiell durch gezielte Ansteuerung der Energieverbrauchs- und/oder Energieerzeugungseinheiten unter Berücksichtigung einer Topologie des Netzabschnitts angestrebt werden.

### FIGURENBESCHREIBUNG

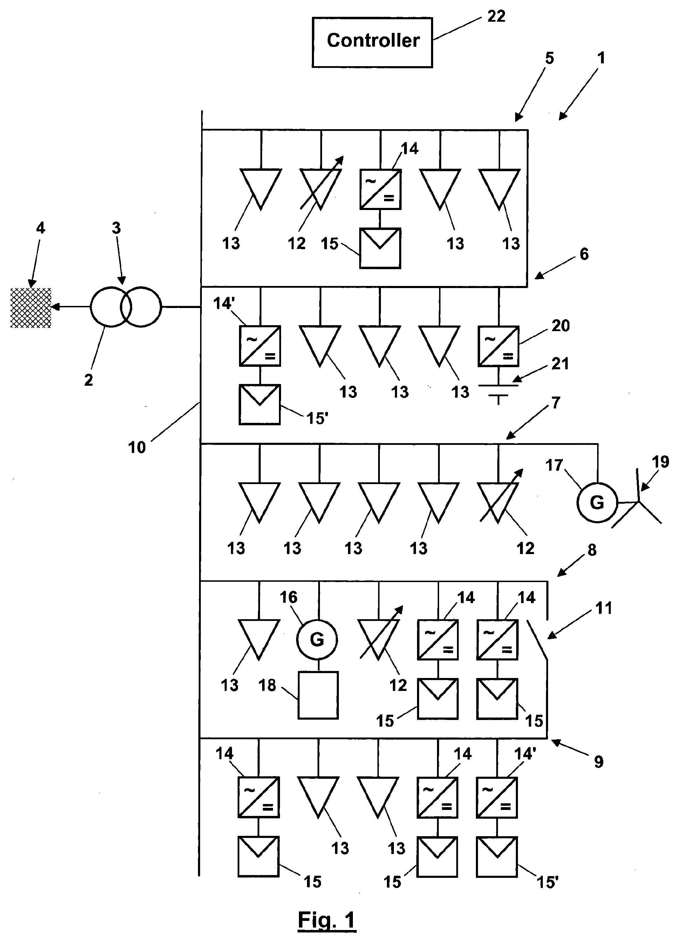

**Fig. 1** zeigt schematisch einen Netzabschnitt 1, der über einen Transformator 2 an einem Netzanschlusspunkt 3 an den Rest eines überlagerten Wechselstromnetzes 4 angeschlossen ist und eine beispielhafte, im Folgenden näher erläuterte elektrische Topologie aufweist. Der Netzabschnitt 1 ist in verschiedene Stränge 5 bis 9 aufgeteilt, die von einer Sammelschiene 10 abgehen und sich weiter in hier nicht dargestellte Teilstränge verzweigen können. Dabei sind die Stränge 5 und 6 an ihrem Ende miteinander verbunden und bilden einen Ring. Der Strang 7 endet frei und zwischen den Strängen 8 und 9 gibt es eine schaltbare Trennstelle 11. Soweit in dem Netzabschnitt 1 keine Blindleistung auftritt, liegt an der Sammelschiene 10 eine durch den Transformator 2 vorgegebene feste Netznennspannung des Netzabschnitts 1 an. Die Stränge 5 bis 9 umfassen (i) Lasten 12, die bezüglich ihrer Anschlussleistung steuerbar sind, und nicht steuerbare Lasten 13 als reine Energieverbrauchseinheiten sowie (ii) Wechselrichter 14 mit angeschlossenen Photovoltaikgeneratoren 15 sowie Generatoren 16 und 17 mit angeschlossenen Brennkraftmaschinen 18 bzw. Windrädern 19 als reine Energieerzeugungseinheiten sowie (iii) Wechselrichter 20 mit angeschlossenem Energiespeicher 21 als Energieverbrauchs- und -erzeugungseinheiten, die sowohl elektrische Energie aufnehmen als auch elektrische Energie abgeben können. Dabei ist die Zahl und Anordnung der verschiedenen Energieverbrauchs- und/oder -erzeugungseinheiten und ihre Verteilung über die Stränge 5 bis 9 willkürlich und zunächst unbekannt. Zudem können sowohl die Lasten 12 und 13 als auch die Energieerzeugungseinheiten für Netzunterabschnitte mit mehreren Energieverbrauchs- und -erzeugungseinheiten stehen, die über einen gemeinsamen Anschluss an den jeweiligen Strang angeschlossen sind, also beispielsweise für Gebäude mit einem Hausanschluss bzw. für Energieerzeugungsanlagen mit mehreren Energieerzeugungseinheiten und einem gemeinsamen Anlagenanschluss. Gemessen werden in dem Netzabschnitt der Energiefluss über den Netzanschlusspunkt 3 und die Netzspannung des Netzabschnitts an dem Netzanschlusspunkt 3. Die Netzspannung wird weiterhin zumindest an den Wechselrichtern 14 und 20, typischerweise aber auch an den Generatoren 16 und 17 gemessen, da diese auf das Wechselstromnetz abgestimmt betrieben werden und dessen Zustand überwachen müssen, beispielsweise in Form einer Inselnetzerkennung. Gleichzeitig wird an den Wechselrichtern 14 und 20 sowie den Generatoren 16 und 17 die Anschlussleistung, d. h. die von den Einheiten in das Wechselstromnetz eingespeiste Wirkleistung und ggf. auch die erzeugte Blindleistung erfasst. Die Anschlussleistung steht auch von den ansteuerbaren Lasten 12 zur Verfügung. Sämtliche Messwerte der Netzspannung und der Anschlussleistung werden an einen Controller 22 übermittelt, der umgekehrt die steuerbaren Lasten 12 und zumindest die Wechselrichter 14 und 20, typischerweise auch die Generatoren 16 und 17 bezüglich ihrer Anschlussleistungen ansteuert. Diese Ansteuerung dient zur Betriebsführung des Wechselstromnetzes in dem Netzabschnitt 1. Dabei können mit der Betriebsführung verschiedene Optimierungsziele angestrebt werden. Zu diesen Optimierungszielen zählt als allererstes die Stabilisierung des Wechselstromnetzes in allen Bereichen des Netzabschnitts 1. Diese Stabilisierung bedeutet zumindest, dass die Netzspannung überall in vorgegebenen Grenzen gehalten wird.

Bei den Wechselrichtern 14 mit angeschlossenen Photovoltaikgeneratoren 15, bei denen die Bezugszeichen mit einem Apostroph versehen sind, stehen die Messwerte der Netzspannung und der Anschlussleistung zwar grundsätzlich zur Verfügung und grundsätzlich mag auch die Anschlussleistung variiert werden können. Doch gilt dies alles nicht für den Controller 22, weil diese Einheiten beispielsweise von einem anderen Hersteller stammen oder von einem anderen Betreiber betrieben werden.

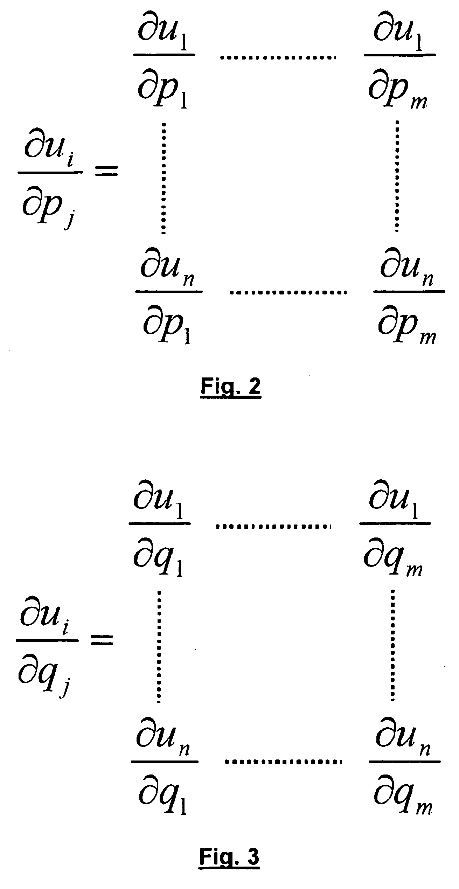

Um die oben angesprochenen Optimierungsziele bei der Betriebsführung in allen Bereichen des Netzabschnitts 1 durch gezielte Ansteuerung der Lasten 12 und der Wechselrichter 14 und 20 erreichen zu können, muss die Topologie des Netzabschnitts bekannt sein. Dies ist häufig nicht oder zumindest nicht mit ausreichender Genauigkeit der Fall. Um dieses Problem zu lösen, werden von dem Controller 22 Abhängigkeiten von Variationen der Netzspannung an allen dem Controller zur Verfügung stehenden Messpunkten des Netzabschnitts 1 und die zeitgleich erfolgenden Variationen der ihm zugänglichen Anschlussleistungen erfasst, und zwar getrennt nach Wirkleistung und Blindleistung der Anschlussleistungen. Diese Abhängigkeiten können in Form der in den **Fig. 2 und 3** wiedergegebenen Matrizen δuᵢ/δpⱼ für die Abhängigkeit der Netzspannung u an den einzelnen Messpunkten i von der Wirkleistung p der Anschlussleistungen der einzelnen Energieverbrauchs- und/oder -erzeugungseinheiten j und δuᵢ/qⱼ für die Abhängigkeit der Netzspannung u von der Blindleistung q dargestellt werden. Soweit die Einträge dieser Matrizen normiert sind, geben sie nicht nur die Abhängigkeiten der Netzspannung an den verschiedenen Messpunkten von den verschiedenen Anschlussleistungen wieder, sondern auch die elektrische Relativlage der einzelnen Einheiten und der Messpunkte zueinander.

So bedeutet ein Eintrag ungleich null in der Matrize δuᵢ/δpⱼ eine ohmsche Kopplung der jeweiligen Energieverbrauchs- und/oder -erzeugungseinheit an den jeweiligen Messpunkt. Eine solche ohmsche Kopplung ist typischerweise nur innerhalb desselben Strangs gegeben und innerhalb einer Phase eines Stranges besonders ausgeprägt. Hingegen finden sich in der Matrize δuᵢ/qⱼ auch (kleine) Einträge ungleich null zu Energieverbrauchs- und/oder -erzeugungseinheiten und Messpunkten in unterschiedlichen Strängen.

Ansteigende Einträge in den Zeilen beider Matrizen, insbesondere aber bei δuᵢ/δpⱼ, weisen auf zunehmende Abstände zwischen der jeweiligen Energieverbrauchs- und/oder -erzeugungseinheit j und dem Netzanschlusspunkt 3 bzw. der Sammelschiene 10 in dem Teil des jeweiligen Strangs hin, der zwischen der Sammelschiene 10 und dem Messpunkt i liegt. Dies liegt daran, dass eine Änderung der Anschlussleistung im Wesentlichen einen geänderten Spannungsabfall nur über den Teil des jeweiligen Strangs 5 bis 9 hervorruft, der zwischen der jeweiligen Energieverbrauchs- und/oder -erzeugungseinheit und der Sammelschiene 10 liegt, an der die feste Netznennspannung anliegt. Dies gilt bei Betrachtungen von Änderungen der Anschlussleistung unabhängig davon, ob der jeweilige Strang insgesamt Leistung von der Sammelschiene bezieht oder in diese einspeist. Aus denselben Gründen weisen etwa gleich große Einträge innerhalb einer Zeile darauf hin, dass die einzelnen Energieverbrauchs- und/oder -erzeugungseinheiten j von der Sammelschiene 10 elektrisch weiter entfernt sind als der Messpunkt i oder in einem anderen Strang angeschlossen sind. Dabei zeigen vergleichsweise große Einträge in δuᵢ/δpⱼ einen bereits großen Abstand des Messpunkts i zu der Sammelschiene 10 an.

Durch Vergleich der Einträge in den einzelnen Zeilen und Spalten beider Matrizen können die einzelnen Messpunkte i und Energieverbrauchs- und/oder -erzeugungseinheiten j nicht nur den einzelnen Strängen 5 bis 9 zugeordnet, sondern auch längs der Stränge 5 bis 9 sortiert werden. Wie genau dies möglich ist, hängt insbesondere von der Dichte der Messpunkte i ab. Eine vorteilhaft hohe Dichte der Messpunkte i ist gegeben, wenn die Netzspannung an jeder Energieverbrauchs- und/oder -erzeugungseinheit j gemessen wird.

Zugleich lässt sich aus den Matrizen δuᵢ/δpⱼ und δuᵢ/δpⱼ unmittelbar ablesen, welche Auswirkungen eine bestimmte Veränderung des Wirkleistungs- oder Blindleistungsanteils der Anschlussleistung einer bestimmten Energieverbrauchs- und/oder -erzeugungseinheit i auf die Spannung an den Messpunkten j hat. Diese Kenntnis nutzt der Controller 22 gemäß Fig. 1, um die ansteuerbaren Einheiten gezielt derart anzusteuern, dass das jeweilige Optimierungsziel bei der Betriebsführung des Wechselstromnetzes im Bereich des Netzabschnitts 1 erreicht wird.

Es können aber nicht nur direkt gemessene Anschlussleistungen ausgewertet werden, sondern auch Anschlussleistungen, die beispielsweise aufgrund eines charakteristischen Zeitverlaufs einer einzelnen Energieverbrauchs- und/oder -erzeugungseinheit zugeordnet werden können. Soweit Vergleichswerte von gemessenen Anschlussleistungen zur Verfügung stehen, kann aus den verfügbaren Messwerten der Netzspannung an den verschiedenen Messpunkten sowohl auf die elektrische Relativlage der jeweiligen Energieverbrauchs- und/oder -erzeugungseinheit geschlossen werden als auch auf die absolute Variation von deren Anschlussleistung.

Die Zuordnung der Variationen der Netzspannung an den einzelnen Messpunkten zu Variationen der Anschlussleistung einzelner Energieverbrauchs- und/oder -erzeugungseinheit kann insbesondere auf Basis von charakteristischen Zeitverläufen der Variationen der Anschlussleistung bzw. der resultierenden Variationen der Netzspannung erfolgen. Dazu zählt die Möglichkeit, eine gemessene witterungsbedingte zeitliche Variation der Anschlussleistung eines der Wechselrichter 14 mit angeschlossenen PV-Generatoren 15, die mit zeitlichem Versatz in vergleichbarer Form auch bei nicht überwachten Wechselrichtern 14' mit PV-Generatoren 15' auftritt, anhand einer Korrelation der resultierenden Variationen der Netzspannung an einem oder mehreren Messpunkten mit der gemessenen witterungsbedingten zeitlichen Variation der Anschlussleistung bzw. der daraus resultierenden Variation der Netzspannung zu erkennen. Dabei kann dieser zeitliche Versatz auch hinsichtlich der räumlichen Relativlage der Energieerzeugungseinheiten ausgewertet werden. Besonders einfach ist die Zuordnung von Variationen der Netzspannung an den Messpunkten jedoch dann, wenn die ursächlichen Variationen der Anschlussleistung der einzelnen Energieverbrauchs- und/oder -erzeugungseinheiten von dem Controller 22 mit definierten Zeitverläufen derart vorgegeben werden, dass sie sich von zufälligen Variationen von Anschlussleistungen und auch untereinander unterscheiden.

Auch der Einfluss der Schaltstellung der Trennstelle 11 auf die Netzspannung an den einzelnen Messpunkten kann als Spalte in eine der Matrizen aufgenommen werden, auch wenn durch die Schaltstellung der Trennstelle 11 keine Anschlussleistung variiert wird.

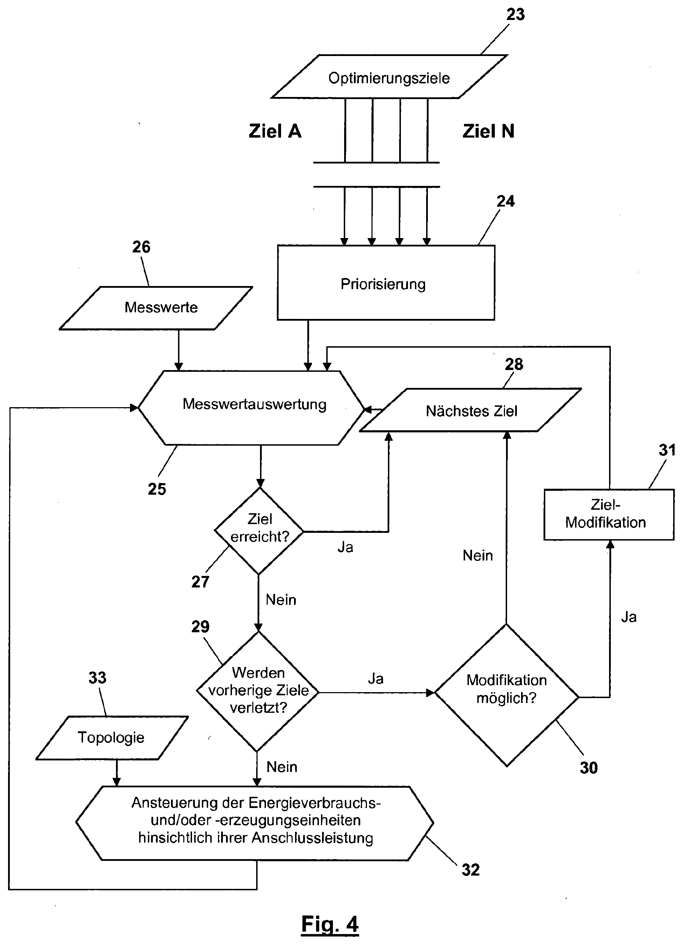

**Fig. 4** beschreibt ein Beispiel für ein Betriebsverfahren für eine Mehrzahl von in einem Netzabschnitt angeordneten Energieverbrauchs- und -erzeugungseinheiten, mit dem verschiedene Optimierungsziele verfolgt werden. Diese Optimierungsziele werden im Schritt 23 vorgegeben und sind zeichnerisch als Ziel A bis Ziel N angedeutet. In einem Schritt 24 erfolgt eine Priorisierung der Optimierungsziele, d. h. die Ausbildung einer Rangfolge. In einem folgenden Schritt 25 werden Messwerte, die im Schritt 26 erfasst werden, dahingehend ausgewertet, inwieweit das erste Optimierungsziel, d. h. das Optimierungsziel mit der höchsten Priorität mit den aktuellen Messwerten, sowieso erreicht ist. Wenn im Schritt 27 festgestellt wird, dass das Optimierungsziel bereits erreicht ist, erfolgt im Schritt 28 der Übergang zum nächsten Optimierungsziel, und in einem neuerlichen Schritt 25 erfolgt die Auswertung der Messwerte dahingehend, inwieweit auch das nächste Optimierungsziel bereits erreicht ist. Wenn jedoch im Schritt 27 festgestellt wird, dass das jeweilige Optimierungsziel noch nicht erreicht ist, wird im Schritt 29 überprüft, ob für das Erreichen dieses Optimierungsziels irgendwelche vorherigen Optimierungsziele, d. h. Optimierungsziele mit höherer Priorität, verletzt werden müssen. Wenn dies der Fall ist, kann das jeweilige Optimierungsziel verworfen und im Schritt 28 direkt zum nächsten Optimierungsziel übergegangen werden. Zuvor kann jedoch im Schritt 30 geprüft werden, ob eine Modifikation des Optimierungsziels möglich ist, die dann im Schritt 31 erfolgt, bevor erneut der Schritt 25 in Bezug auf das modifizierte Optimierungsziel durchgeführt wird. Wenn hingegen im Schritt 29 festgestellt wird, dass die Erfüllung des jeweiligen Optimierungsziels keine Optimierungsziele mit höherer Priorität verletzt, so erfolgt im Schritt 32 die Ansteuerung der hierfür verfügbaren Energieverbrauchs- und -erzeugungseinheiten in dem Netzabschnitt hinsichtlich ihrer Anschlussleistung, und zwar sowohl in Bezug auf deren Wirkleistungs- als auch Blindleistungsanteil, um das aktuelle Optimierungsziel zu erreichen. Dabei wird die gemäß dem oben beschriebenen Verfahren im Schritt 33 erfasste Topologie des Netzabschnitts berücksichtigt, insbesondere in Form der Matrizen gemäß den Fig. 2 und 3. Ob mit der Ansteuerung im Schritt 32 das jeweilige Optimierungsziel erreicht wird, wird dann bei 25 überprüft. Die Ansteuerung im Schritt 32 zum Erreichen des jeweiligen Optimierungsziels wird vorzugsweise als Modifikation der Ansteuerung der Energieverbrauchs- und -erzeugungseinheiten hinsichtlich ihrer Anschlussleistung vorgenommen, die bereits zur Erreichung aller bisherigen, d. h. höher priorisierten Optimierungsziele durchgeführt wird, zumindest soweit zur Erreichung dieser vorherigen Optimierungsziele eine dauerhafte Ansteuerung der Energieverbrauchs- und/oder -erzeugungseinheiten erforderlich ist und keine vorübergehende Ansteuerung ausreicht.

### BEZUGSZEICHENLISTE

- 1: Netzabschnitt
- 2: Transformator
- 3: Netzanschlusspunkt
- 4: Wechselstromnetz
- 5: Strang
- 6: Strang
- 7: Strang
- 8: Strang
- 9: Strang
- 10: Sammelschiene
- 11: Trennstelle
- 12: steuerbare Last
- 13: Last
- 14: Wechselrichter
- 15: PV-Generator
- 16: Generator
- 17: Generator
- 18: Brennkraftmaschine
- 19: Windrad
- 20: Wechselrichter
- 21: Energiespeicher
- 22: Controller
- 23-33: Schritt des Betriebsverfahrens

## Patentansprüche

1. Verfahren zum Ermitteln der Topologie eines Netzabschnitts (1) eines Wechselstromnetzes (4), der einen Netzanschlusspunkt (3), mindestens einen von dem Netzanschlusspunkt (3) abgehenden Strang (5-9) mit mehreren Energieverbrauchs- und/oder -erzeugungseinheiten und mindestens einen Messpunkt in dem mindestens einen Strang (5-9) umfasst, mit den Schritten:
- Messen der Anschlussleistung mindestens einer der mehreren Energieverbrauchs- und/oder -erzeugungseinheiten und
- Messen der Netzspannung an dem mindestens einen Messpunkt;
**gekennzeichnet durch** den weiteren Schritt:
- Bestimmen von Abhängigkeiten von Variationen der Netzspannung an dem mindestens einen Messpunkt von Variationen der Anschlussleistungen von zumindest einigen einzelnen der mehreren Energieverbrauchs- und/oder -erzeugungseinheiten.

2. Verfahren nach Anspruch 1, **dadurch gekennzeichnet, dass** die beim Bestimmen der Abhängigkeiten berücksichtigten Variationen der Anschlussleistungen Variationen der Wirkleistung und/oder der Blindleistung der zumindest einigen einzelnen der mehreren Energieverbrauchs- und/oder -erzeugungseinheiten umfassen.

3. Verfahren nach Anspruch 1 oder 2, **dadurch gekennzeichnet, dass** elektrische Relativlagen der einigen einzelnen Energieverbrauchs- und/oder -erzeugungseinheiten zu dem mindestens einem Messpunkt und dem Netzanschlusspunkt aus den bestimmten Abhängigkeiten ermittelt werden, wobei die elektrischen Relativlagen der einigen einzelnen Energieverbrauchs- oder -erzeugungseinheiten optional anhand einer Korrelationsanalyse der Variationen der Netzspannungen und der Variationen der Anschlussleistungen ermittelt werden.

4. Verfahren nach Anspruch 3, **dadurch gekennzeichnet, dass** zur Ermittlung der elektrischen Relativlagen ermittelt wird, ob der mindestens eine Messpunkt und die einzelnen der Energieverbrauchs- und/oder -erzeugungseinheiten an derselben Phase des Wechselstromnetzes (4) und/oder in demselben Strang angeschlossen sind, wobei für den mindestens einen Messpunkt und diejenigen der einzelnen Energieverbrauchs- und/oder-erzeugungseinheiten, die in demselben Strang angeschlossen sind, optional eine von dem Netzanschlusspunkt aus gesehene Reihenfolge des Anschlusses entlang des Stranges ermittelt wird.

5. Verfahren nach einem der Ansprüche 1 bis 4, **dadurch gekennzeichnet, dass** die Variationen der Anschlussleistungen direkt an allen der einigen einzelnen Energieverbrauchs- oder -erzeugungseinheiten gemessen werden.

6. Verfahren nach einem der Ansprüche 1 bis 4, **dadurch gekennzeichnet, dass** die Variationen der Anschlussleistungen von einigen einzelnen Energieverbrauchs- und/oder -erzeugungseinheiten aus den Variationen der Netzspannung abgeleitet werden, wobei die Variationen der Netzspannung den einzelnen Energieverbrauchs- und/oder -erzeugungseinheiten anhand von charakteristischen Zeitverläufen ihrer Anschlussleistungen zugeordnet werden.

7. Verfahren nach Anspruch 6, **dadurch gekennzeichnet, dass** zunächst unbekannte Energieerzeugungseinheiten anhand von Variationen der Netzspannung aufgrund von witterungsbedingten Variationen ihrer Anschlussleistungen erkannt werden, die gegenüber Variationen der Netzspannung aufgrund von witterungsbedingten Variationen der direkt gemessenen Anschlussleistung mindestens einer bekannten Energieerzeugungseinheit zeitlich versetzt sind, wobei erkannte Energieerzeugungseinheiten mit PV-Generatoren (15') oder Windenergieanlagen (19) optional auf Basis der zeitlich versetzten Variationen ihrer Anschlussleitung gegenüber bekannten Energieerzeugungseinheiten mit PV-Generatoren (15) oder Windenergieanlagen (19) räumlich eingeordnet werden.

8. Verfahren nach Anspruch 7, **dadurch gekennzeichnet, dass** nach dem Bestimmen der Abhängigkeit bestimmter Variationen der Netzspannung von Variationen der direkt gemessenen Anschlussleistung mindestens einer bekannten Energieerzeugungseinheit die gemessene Netzspannung auf das Auftreten von Variationen, die mit den bestimmten Variationen gleichartig sind, aber nicht von Variationen der direkt gemessenen Anschlussleistung der mindestens einen bekannten Energieerzeugungseinheit abhängen, untersucht wird und dass aus dem Auftreten von gleichartigen Variationen auf das Vorhandensein mit der mindestens einen bekannten Energieerzeugungseinheit gleichartiger Energieerzeugungseinheiten geschlossen wird, wobei optional eine Korrelationsanalyse der Netzspannung in Hinblick auf die bestimmten Variationen der Netzspannung durchgeführt wird, um die damit gleichartigen Variationen der Netzspannung zu erkennen.

9. Verfahren nach einem der vorhergehenden Ansprüche, **dadurch gekennzeichnet, dass** die Variationen der Anschlussleistungen einzelner der Energieverbrauchs- und -erzeugungseinheiten erzwungen werden.

10. Verfahren nach einem der vorhergehenden Ansprüche, **dadurch gekennzeichnet, dass** die gemessenen Variationen der Anschlussleistungen ausschließliche Variationen der Wirkleistung und/oder der Blindleistung der jeweiligen Energieverbrauchs- und/oder -erzeugungseinheiten sind.

11. Betriebsverfahren für eine Mehrzahl von Energieverbrauchs- und/oder -erzeugungseinheiten, die in einem Netzabschnitt (1) eines Wechselstromnetzes (4) angeordnet und in ihrer Anschlussleistung zum Erreichen mindestens eines vorgegebenen Optimierungsziels steuerbar sind, wobei beim Steuern der Energieverbrauchs- und/oder -erzeugungseinheiten eine Topologie des Netzabschnitts (1) berücksichtigt wird, **dadurch gekennzeichnet, dass** die Topologie nach einem Verfahren nach einem der vorhergehenden Ansprüche ermittelt wird.

12. Betriebsverfahren nach Anspruch 11, **dadurch gekennzeichnet, dass** das mindestens eine Optimierungsziel ausgewählt aus:
- einem Fernhalten aller Betriebsparameter des Netzabschnitts von Stabilitätsgrenzen;
- einem definierten Lastfluss an einem Netzanschlusspunkt (3), über die der Netzabschnitt (1) an das weitere Wechselstromnetz angeschlossen ist;
- einer maximalen Nutzung einer in dem Netzabschnitt (1) zur Verfügung stehenden Netzkapazität;
- einer maximalen Schonung der steuerbaren Energieverbrauchs- und -erzeugungseinheiten;
- einer Maximierung wirtschaftlicher Vorteile;
- einer maximalen Nutzung von Energie von regenerativen Energieerzeugungseinheiten, wobei optional mehrere Optimierungsziele nacheinander angestrebt werden, wobei zum Erreichen eines weiteren Optimierungsziels jeweils nur solche Maßnahmen ergriffen werden, die dem Erhalten eines bereits erreichten Optimierungsziels nicht entgegenstehen.

13. Betriebsverfahren nach Anspruch 12, **dadurch gekennzeichnet, dass** mehrere Optimierungsziele gleichzeitig angestrebt werden, wobei die gleichzeitig angestrebten Optimierungsziele optional unterschiedlich gewichtet werden.

14. Betriebsverfahren nach einem der Ansprüche 11 bis 13, **dadurch gekennzeichnet, dass** das mindestens eine Optimierungsziel und/oder die Reihenfolge oder Gewichtung mehrerer Optimierungsziele von einer Netzleitstelle des Wechselstromnetzes vorgegeben wird/werden.

15. Betriebsverfahren nach einem der Ansprüche 11 bis 14, **dadurch gekennzeichnet, dass** die steuerbaren Energieverbrauchs- und/oder -erzeugungseinheiten bezüglich ihrer Effizienz bei der Ansteuerung zum Erreichen des mindestens einen Optimierungsziels gerankt und in der Reihenfolge ihres Rankings zum Erreichen des Optimierungsziels angesteuert werden.

## Claims

1. A method of determining a topology of a grid section (1) of an AC power grid (4), the grid section (1) comprising a grid connection point (3), at least one branch (5-9) branching off from the grid connection point (3) and including a plurality of energy consumption and/or generation units, and at least one measurement point in the at least one branch (5-9), the method comprising:
- measuring connection power values of at least one of the plurality of energy consumption and/or generation units, and
- measuring the grid voltage at the at least one measurement point;
**characterised by** the further step of
- determining dependencies of variations of the grid voltage at the at least one measurement point on variations of connection power values of at least some individual energy consumption and/or generation units of the plurality of energy consumption and/or generation units.

2. The method of claim 1, **characterised in that** the variations of the connection power values considered in determining the dependencies include variations of the active power and/or the reactive power of the at least some individual energy consumption and/or generation units.

3. The method of claim 1 or 2, **characterised in that** electric relative positions of the at least some individual energy consumption and/or generation units with regard to the at least one measurement point and the grid connection point are determined from the determined dependencies, wherein, optionally, the electric relative positions of the at least some individual energy consumption and/or generation units are determined based on a correlation analysis of the variations of the grid voltage and the variations of the connection power values.

4. The method of claim 3, **characterised in that**, for determining the electric relative positions, it is determined whether the at least one measurement point and the at least some individual energy consumption and/or generation units are connected to a same phase of the AC power grid (4) and/or to a same branch, wherein, optionally, for the at least one measurement point and those of the at least some individual energy consumption and/or generation units that are connected to the same branch, a sequence of connection to the same branch from the point of view of the grid connection point is determined.

5. The method of one of the claims 1 to 4, **characterised in that** the variations of the connection power values are measured directly at all of the at least some individual energy consumption and/or generation units.

6. The method of one of the claims 1 to 4, **characterised in that** the variations of the connection power values of some of the at least some individual energy consumption and/or generation units are derived from variations of the grid voltage, wherein the variations of the grid voltage are assigned to the individual energy consumption and/or generation units based on characteristic time courses of their connection power values.

7. The method of claim 6, **characterised in that** at first unknown energy generation units of the at least some individual energy consumption and/or generation units are recognized based on variations of the grid voltage due to weather-dependent variations of their connection power values which are offset in time with regard to variations of the grid voltage due to weather-based variations of the measured connection power values of at least one known energy generation unit of the at least some individual energy consumption and/or generation units, wherein, optionally, a spatial arrangement of recognized energy generation units including photovoltaic generators or wind generators is determined based on variations of their connection power values time-wise offset with regard to known energy generation units including photovoltaic generators or wind generators.

8. The method of claim 7, wherein, after determining the dependency of certain variations of the grid voltage on variations of the measured connection power values of at least one known energy generation unit of the at least some individual energy consumption and/or generation units, the measured grid voltage is evaluated for the occurrence of variations which are similar to the determined variations but which are not dependent on variations of the directly measured connection power values of the at least one known energy generation unit, and that from the occurrence of similar variations a conclusion is drawn on the presence of energy generation units that are similar to the at least one known energy generation unit, wherein, optionally, a correlation analysis of the grid voltage with regard to the determined variations of the grid voltage is made to recognize similar variations of the grid voltage.

9. The method of one of the previous claims, **characterised in that** the variations of the connection power values of single ones of the at least some individual energy consumption and/or generation units are forced.

10. The method of one the previous claims, **characterised in that** the measured connection power values of the at least one of the at least some individual energy consumption and/or generation units are pure active or the reactive power values.

11. A method of operating a plurality of energy consumption and/or generation units which are included in a grid section (1) of an AC power grid (4) and which are controllable with regard to their connection power values for achieving at least one optimization aim, wherein in controlling the energy consumption and/or generation units, a topology of the grid section is considered, **characterised in that** topology is determined by a method according to one of the previous claims.

12. The method of operating of claim 11, **characterised in that** the at least one optimization aim is selected from:
- keeping away all operation parameters of the grid section from stability limits;
- a defined power flow at a grid connection point (3) via which the grid section (1) is connected to the further AC power grid;
- a maximum usage of grid capacity available in the grid section (1);
- a maximum protection of the controllable energy consumption and/or generation units;
- a maximization of economic advantages;
- a maximum usage of energy from regenerative energy generation units,
wherein, optionally, a plurality of optimization aims is strived for one after the other, wherein for achieving a further optimization aim only such measures are taken which do not violate the conservation of an already achieved optimization aim.

13. The method of operating of claim 12, **characterised in that** a plurality of optimization aims is strived for simultaneously, wherein, optionally, the optimization aims strived for simultaneously are weighted differently.

14. The method of operating of one of the claims 11 to 13, **characterised in that** the at least one optimization aim or a sequence or a weighting of a plurality of optimization aims is predetermined by a grid control center of the AC power grid.

15. The method of operating of one of the claims 11 to 14, **characterised in that** the controllable energy consumption and/or generation units are ranked with regard to their efficiency in being controlled for achieving the at least one optimization aim, and that the controllable energy consumption and/or generation units are controlled in the sequence of their ranking for achieving the at least one optimization aim.

## Revendications

1. Procédé de détermination de la topologie d'un segment de réseau (1) d'un réseau de courant alternatif (4), qui comprend un point de connexion au réseau (3), au moins une branche (5-9) sortant du point de connexion au réseau (3) avec plusieurs unités consommatrices d'énergie et/ou génératrices d'énergie et au moins un point de mesure dans l'au moins une branche (5-9), comportant les étapes de :
- mesure de la puissance de connexion d'au moins une de la pluralité d'unités consommatrices d'énergie et/ou génératrices d'énergie et
- mesure de la tension de réseau sur l'au moins un point de mesure ; **caractérisé par** l'étape supplémentaire de :
- détermination des dépendances des variations de la tension de réseau sur l'au moins un point de mesure des variations des puissances de connexion d'au moins quelques unités individuelles de la pluralité d'unités consommatrices d'énergie et/ou génératrices d'énergie.

2. Procédé selon la revendication 1, **caractérisé en ce que** les variations des puissances de connexion prises en compte lors de la détermination des dépendances comprennent des variations de la puissance active et/ou de la puissance réactive d'au moins quelques unités individuelles de la pluralité d'unités consommatrices d'énergie et/ou génératrices d'énergie.

3. Procédé selon la revendication 1 ou 2, **caractérisé en ce que** les positions relatives électriques des quelques unités consommatrices d'énergie et/ou génératrices d'énergie individuelles par rapport à l'au moins un point de mesure et au point de connexion au réseau sont déterminées d'après les dépendances déterminées, dans lequel les positions relatives électriques des quelques unités consommatrices d'énergie et/ou génératrices d'énergie individuelles sont déterminées optionnellement sur la base d'une analyse de corrélation des variations de tension de réseau et des variations des puissances de connexion.

4. Procédé selon la revendication 3, **caractérisé en ce que** pour déterminer les positions relatives électriques, il est déterminé si l'au moins un point de mesure et les unités consommatrices d'énergie et/ou génératrices d'énergie individuelles sont connectées à la même phase du réseau de courant alternatif (4) et/ou dans la même branche, dans lequel pour l'au moins un point de mesure et les unités consommatrices d'énergie et/ou génératrices d'énergie individuelles qui sont connectées dans la même branche, il est déterminé optionnellement une séquence de connexion le long de la branche vue à partir du point de connexion au réseau.

5. Procédé selon une des revendications 1 à 4, **caractérisé en ce que** les variations des puissances de connexion sont mesurées directement sur toutes les quelques unités consommatrices d'énergie ou génératrices d'énergie individuelles.

6. Procédé selon une des revendications 1 à 4, **caractérisé en ce que** les variations des puissances de connexion de quelques unités consommatrices d'énergie et/ou génératrices d'énergie individuelles sont déduites d'après les variations de la tension de réseau, dans lequel les variations de la tension de réseau sont affectées aux unités consommatrices d'énergie et/ou génératrices d'énergie individuelles sur la base des courbes temporelles caractéristiques de leurs puissances de connexion.

7. Procédé selon la revendication 6, **caractérisé en ce que** des unités génératrices d'énergie d'abord inconnues sont reconnues sur la base de variations de la tension de réseau en raison de variations déterminées par les conditions climatiques de leurs puissances de connexion, qui sont décalées temporellement par rapport aux variations de la tension de réseau en raison de variations déterminées par les conditions climatiques de la puissance de connexion directement mesurée d'au moins une unité de génération d'énergie connue, dans lequel des unités génératrices d'énergie reconnues sont classées spatialement avec des générateurs PV (15') ou des installations d'énergie éolienne (19) optionnellement sur la base des variations décalées temporellement de leur puissance de connexion par rapport aux unités génératrices d'énergie connues avec des générateurs PV (15) ou des installations d'énergie éolienne (19).

8. Procédé selon la revendication 7, **caractérisé en ce qu'**après la détermination de la dépendance de variations déterminées de la tension de réseau par rapport aux variations de la puissance de connexion directement mesurée d'au moins une unité génératrice d'énergie connue, la tension de réseau mesurée est examinée pour rechercher l'apparition de variations, qui sont identiques aux variations déterminées, mais ne dépendent pas des variations de la puissance de connexion directement mesurée de l'au moins une unité génératrice d'énergie connue, et **en ce que** d'après l'apparition de variations identiques on conclut à la présence avec l'au moins une unité génératrice d'énergie connue d'unités génératrices d'énergie identiques, dans lequel optionnellement une analyse de corrélation de la tension de réseau en ce qui concerne les variations déterminées de la tension de réseau est effectuée, afin de reconnaître les variations identiques de la tension de réseau.

9. Procédé selon une des revendications précédentes, **caractérisé en ce que** les variations des puissances de connexion des unités consommatrices d'énergie et génératrices d'énergie individuelles sont imposées.

10. Procédé selon une des revendications précédentes, **caractérisé en ce que** les variations mesurées des puissances de connexion excluent les variations de la puissance active et/ou de la puissance réactive des unités consommatrices d'énergie et/ou génératrices d'énergie respectives.

11. Procédé de fonctionnement d'une pluralité d'unités consommatrices d'énergie et/ou génératrices d'énergie, qui sont disposées dans un segment de réseau (1) d'un réseau de courant alternatif (4) et peuvent être commandées en ce qui concerne leur puissance de connexion afin d'atteindre au moins un objectif d'optimisation prescrit, dans lequel lors de la commande des unités consommatrices d'énergie et/ou génératrices d'énergie une topologie du segment de réseau (1) est prise en compte, **caractérisé en ce que** la topologie est déterminée selon un procédé selon une des revendications précédentes.

12. Procédé de fonctionnement selon la revendication 11, **caractérisé en ce qu'**au moins un objectif d'optimisation est sélectionné parmi :
- un respect des limites de stabilité de tous les paramètres de fonctionnement du segment de réseau ;
- un flux de charge défini sur un point de connexion au réseau (3), via lequel le segment de réseau (1) est raccordé à l'autre réseau de courant alternatif ;
- une utilisation maximale d'une capacité de réseau disponible dans le segment de réseau (1),
- une préservation maximale des unités consommatrices d'énergie et génératrices d'énergie pouvant être commandées ;
- une maximisation des avantages économiques ;
- une utilisation maximale de l'énergie des unités génératrices d'énergie régénératives,
dans lequel optionnellement plusieurs objectifs d'optimisation sont visés les uns après les autres, dans lequel pour atteindre un autre objectif d'optimisation ne sont à chaque fois prises que des mesures qui ne s'opposent pas au respect d'un objectif d'optimisation déjà atteint.

13. Procédé de fonctionnement selon la revendication 12, **caractérisé en ce que** plusieurs objectifs d'optimisation sont visés simultanément, dans lequel les objectifs d'optimisation visés simultanément sont optionnellement pondérés différemment.

14. Procédé de fonctionnement selon une des revendications 11 à 13, **caractérisé en ce qu'**au moins un objectif d'optimisation et/ou la séquence ou la pondération de plusieurs objectifs d'optimisation est/sont prescrit(e)(s) à partir d'un poste de conduite du réseau de courant alternatif.

15. Procédé de fonctionnement selon une des revendications 11 à 14, **caractérisé en ce que** les unités consommatrices d'énergie et/ou génératrices d'énergie pouvant être commandées sont hiérarchisées en ce qui concerne leur efficacité lors de la commande afin d'atteindre l'au moins un objectif d'optimisation et sont commandées dans la séquence de leur hiérarchisation afin d'atteindre l'objectif d'optimisation.
